# EUROPEAN PATENT APPLICATION

(11) **EP 3 051 598 A1**
(43) Date of publication of application: **03.08.2016**
(21) Application number: 14849187.1
(22) Date of filing: 25.09.2014
(51) Int. Cl.: H01L 33/62, H01L 21/60, H01L 33/60

(54) **LIGHT EMITTING DEVICE, ANISOTROPIC CONDUCTIVE ADHESIVE AND METHOD FOR MANUFACTURING LIGHT EMITTING DEVICE**

(30) Priority: 26.09.2013 JP 2013199258
(71) Applicant: Dexerials Corporation, Tokyo 141-0032 (JP)
(72) Inventor: NAMIKI, Hidetsugu, Kanuma-shi Tochigi 322-8502 (JP); KANISAWA, Shiyuki, Kanuma-shi Tochigi 322-8502 (JP); ISHIGAMI, Akira, Kanuma-shi Tochigi 322-8502 (JP)
(74) Representative: Körber, Martin Hans
(86) International application number: PCT/JP2014/075421
(87) International publication number: WO 2015/046326

(57) **Abstract**

In order to provide a light emitting device having high connection reliability, the light-emitting device includes a board (10) provided with a wiring pattern (11), an anisotropic conductive paste (23) arranged on an board electrode (12) of the wiring pattern (11), and a light-emitting element (30) embedded in the anisotropic conductive paste (23), and at least one of the board electrode (12) and the element electrode (31) is plated with an AuSn alloy layer (34). The anisotropic conductive paste (23) contains an epoxy compound, an acid anhydride, white inorganic particles, and conductive particles (8) obtained by coating resin particles with an Au coating layer. It is possible to maintain electrical connection between the board electrode (12) and the element electrode (31) by the Au coating layers of the conductive particles even when a crack is generated in a eutectic bonding portion. Therefore, it is possible to obtain high connection reliability.

## Description

### Technical Field

The present invention relates to a light-emitting device obtained by connecting a light-emittin g element such as a light-emitting diode (LED) and a wiring board.

### Background Art

As a method of packaging a chip component such as a light-emitting diode (LED) on a circuit board, there is widely employed a flip chip packaging method in which an anisotropic conductive paste (ACP) obtained by dispersing conductive particles into an epoxy-based adhesive is used (for example, refer to Patent Literatures 1 and 2). According to this method, electric connection between the chip component and the circuit board is achieved by conductive particles of an anisotropic conductive film. Therefore, it is possible to reduce a connection process and improve production efficiency.

In addition, a metal eutectic bonding method is also employed, in which metal eutectic bonding represented by AuSn and solder is used in electric connection between the chip component and the circuit board (for example, refer to Patent Literature 3).

However, since the chip component and the circuit board have different linear expansion coefficients, a crack may be generated by a stress in the metal eutectic bonding, and a connection failure may occur. In addition, materials such as AuSn or solder necessitate flux coating in order to remove an oxide film on a surface, and this degrades production efficiency.

### Citation List

### Patent Literatures

Patent Literature 1: JP 2010-24301 A
Patent Literature 2: JP 2012-186322 A
Patent Literature 3: JP 2003-234427 A

### Summary of Invention

### Problems to be solved by the Invention

The present invention is made by consideration to solve the problems of the conventional technologies as state above, and has an object of providing a light-emitting device having high connection reliability.

### Means for solving the problems

In order to solve the above mentioned problem, the present invention is a light-emitting device comprising a board provided with a wiring pattern, a board electrode provided in the board and connected to the wiring pattern, a light-emitting element which emits light when a current is flowed, and an element electrode provided in the light-emitting element and connected to a semiconductor region in an inside of the light-emitting element, wherein the board electrode and the element electrode are electrically connected to each other, and when a voltage is applied to the board electrode, a current is flowed through the light-emitting element so as to emits light, the light-emitting device further comprising, a solidified layer of molten AuSn formed by solidifying a molten AuSn product which is obtained from melting an AuSn alloy layer positioned between the board electrode and the element electrode in the state of the molten AuSn product contacting with both the board electrode and the element electrode, and a plurality of conductive particles which are contained in an inside of the molten AuSn product and made contact with the board electrode and the element electrode when the molten AuSn product is solidified, wherein the solidified layer of molten AuSn and the element electrode are connected with a eutectic bonding portion which is formed in a contact region where the solidified layer of molten AuSn and the element electrode are connected each other, and the solidified layer of molten AuSn and the board electrode are connected with the eutectic bonding portion which is formed in a contact region where the solidified layer of molten AuSn and the board electrode are connected each other. The present invention is the light-emitting device, wherein the AuSn alloy layer is formed through plating in any one of electrodes between the board electrode and the element electrode, an Au plating layer is formed in the other electrode, and wherein the molten AuSn product is solidified in a state of making contact with the Au plating layer.

The present invention is the light-emitting device, wherein the conductive particles include resin particles and Au coating layers coated on the resin particles, wherein the solidified layer of molten AuSn is formed by solidifying the molten AuSn product while the molten AuSn product is in contact with the Au coating layer, and wherein an eutectic bonding portion is formed in a contact region between the solidified layer of molten AuSn and the Au coating layer where these layers are in contact with each other.

The present invention is the light-emitting device, wherein the outside between the board electrode and the element electrode are bonded to each other by a cured product of an anisotropic conductive paste including white inorganic particles and the conductive particles.

The present invention is the light-emitting device, wherein the cured product is an epoxy resin inclding an alicyclic epoxy compound or a hydrogenated epoxy compound.

The present invention is the light-emitting device, wherein an average particle diameter of the conductive particles is at least 2 µm and at most 30 µm.

The present invention is a light-emitting device comprising a board provided with a wiring pattern, a board electrode provided in the board and connected to the wiring pattern and a light-emitting element that emits light when a current is applied an element electrode provided in the light-emitting element and connected to a semiconductor region in an inside of the light-emitting element,and wherein the board electrode and the element electrode are electrically connected to each other, and the light-emitting element emits light by flowing a current when a voltage is applied to the board electrode, and the light-emitting device further comprising a connecting bump which is provided on any one of electrodes between the board electrode and the element electrode and which is a solder bump or an Au bump having Au exposed on a surface, a solidified layer of molten AuSn formed by solidifying a molten AuSn product which is obtained by melting an AuSn alloy layer positioned between the other electrode and the connecting bump in a state such that the molten AuSn product is in contact with both the other electrode and the connecting bump, a plurality of conductive particles which are contained in an inside of the molten AuSn product, and the plurality of conductive particles are made contact with the board electrode and the element electrode when the molten AuSn product is solidified, and eutectic bonding portion formed on a region between the solidified layer of molten AuSn and the other being in contact with each other, and a region between the solidified layer of molten AuSn and the connecting bump being in contact with each other and they are connected by the eutectic bonding portion. The present invention is the light-emitting device, wherein the AuSn alloy layer is formed by plating on the other electrode.

The present invention is the light-emitting device, wherein the Au plating layer formed by plating is arranged on a surface of the other electrode.

The present invention is the light-emitting device, wherein the conductive particles include resin particles and Au coating layers coated on the resin particles, wherein the solidified layer of molten AuSn is formed by solidifying the molten AuSn product which is in contact with the Au coating layer, and wherein the solidified layer of molten AuSn and the Au coating layer are connected by the eutectic bonding portion formed in a region where the solidified layer of molten AuSn and the Au coating layer are in contact with each other.

The present invention is an anisotropic conductive paste for fixing a light-emitting element on a board and connecting an element electrode on a board electrode electrically, wherein a light-emitting device has the board and the light-emitting element, an AuSn alloy layer provided on at least any one of electrodes between the board electrode provided in the board and the element electrode provided in the light-emitting element, and an AuSn eutectic bonding layer is formed between the AuSn alloy layer and the other electrode, the anisotropic conductive paste comprising, an epoxy compound, an acid anhydride, white inorganic particles, and conductive particles obtained by coating Au coating layers on resin particles.

The present invention is an anisotropic conductive paste for fixing a light-emitting element on a board and connecting an element electrode on a board electrode electrically, wherein a light-emitting device has the board and the light-emitting element, and between the board electrode provided in the board and the element electrode provided in the light-emitting element, at least any one of electrodes is provided a connecting bump which is a solder bump or an Au bump exposed Au on a surface, the other electrode is provided AuSn alloy layer, and an AuSn eutectic bonding layer is formed between the connecting bunp and the AuSn alloy layer,
the anisotropic conductive paste comprising, an epoxy compound, an acid anhydride, white inorganic particles, and conductive particles obtained by coating Au coating layers on resin particles.

The present invention is a method of manufacturing a light-emitting device, the light-emitting device including, a board provided with a wiring pattern, a board electrode provided in the board and connected to the wiring pattern, a light-emitting element that emits light when a current is applied, and an element electrode provided in the light-emitting element and connected to a semiconductor region in an inside of the light-emitting element, wherein the board electrode and the element electrode are electrically connected to each other, and when a voltage is applied to the board electrode, a current is flowed through the light-emitting element so as to emits light, the method comprising the steps of forming an AuSn alloy layer by plating in at least any one of electrodes between the board electrode and the element electrode, then, arranging the light-emitting element and the board in a state such that the other electrode and the AuSn alloy layer face each other while an anisotropic conductive paste including a thermosetting resin and conductive particles is arranged between the other electrode and the AuSn alloy layer, pressing one of the light-emitting element and the board to the other one while heating, forming a molten AuSn product melted from the AuSn alloy layer by pressing and heating the AuSn alloy layer and the other electrode so as to be in contact with the anisotropic conductive paste, flowing out the anisotropic conductive paste from a gap between the element electrode and the board electrode while being the conductive particles in contact with the element electrode and the board electrode, and curing the thermosetting resin, forming the solidified layer of molten AuSn by cooling and solidifying the molten AuSn product while being the molten AuSn product in contact with the element electrode, the board electrode, and the conductive particles, and being the conductive particles in contact with the element electrode and the board electrode, and bonding by eutectic bonding portion formed in a region between the solidified layer of molten AuSn and the element electrode, and a region between the solidified layer of molten AuSn and the board electrode.

The present invention is the method according to claim 13, further comprising the steps of including an acid anhydride in the anisotropic conductive paste, and removing oxides formed on a surface of the AuSn alloy layer being in contact with the anisotropic conductive paste and a surface of the other electrode by melting. The present invention is the method according to claim 13, further comprising the steps of forming the Au plating layer on the other electrode in advance, and solidifying the molten AuSn product being in contact with the Au plating layer.

The method according to any one of claims 13 to 15, wherein the conductive particles include resin particles and Au coating layers coated on the resin particles, the method further comprising the steps of solidifying the molten AuSn product being in contact with the Au coating layer and so as to form the solidified layer of molten AuSn, and forming an eutectic bonding portion in a region between solidified layer of molten AuSn and the Au coating layer where these layers are in contact with each other.

The method according to claim 13, wherein an epoxy group-containing compound is used as the thermosetting resin, and the epoxy group-containing compound includes an alicyclic epoxy compound or a hydrogenated epoxy compound.

The method according to claim 13, wherein an average particle diameter of the conductive particles is at least 2 µm and at most 30 µm.

### Advantageous Effects of Invention

According to the present invention, it is possible to maintain electrical connection by the conductive particles even when a crack is generated in the AuSn eutectic bonding, and high connection reliability can be obtained.

Since necessity of fluxing for removing the AuSn alloy layer or the oxide film on the surface of the electrode is eliminated, and production efficiency improves.

### Brief Description of Drawings

FIG. 1 is a cross-sectional view illustrating an exemplary light-emitting device;
FIG. 2(A) is a cross-sectional view schematically illustrating an exemplary state between an element electrode and a board electrode before thermal compression bonding;
FIG. 2(B) is a cross-sectional view schematically illustrating an exemplary connection state between the element electrode and the board electrode after the thermal compression bonding;
FIG. 3 is a cross-sectional view illustrating an exemplary state that an Au bump is formed on the element electrode;
FIG. 4(A) is a cross-sectional view schematically illustrating an exemplary state between the Au bump and the board electrode before thermal compression bonding; and
FIG. 4(B) is a cross-sectional view schematically illustrating an exemplary state between the Au bump and the board electrode after the thermal compression bonding.

### Description of Embodiments

A description will now be made for embodiments of the present invention with reference to the drawings. It is noted that the embodiments described below are not intended to limit the present invention, but various changes or modifications may be possible within the scope of the summary of the present invention.

Also, the drawings are just for illustrative purposes, and ratios or dimensions thereof may be different from real ones. Specific dimensions and the like should be determined by reading the following description. In addition, different portions in mutual dimensional relationships or ratios are contained among the drawings.

The description will be made on the basis of the following sequence.
1. Light-emitting Device
2. Method of Manufacturing Light-emitting Device
3. Anisotropic Conductive Paste

### 1. Embodiments

### <1. Light-emitting Device>

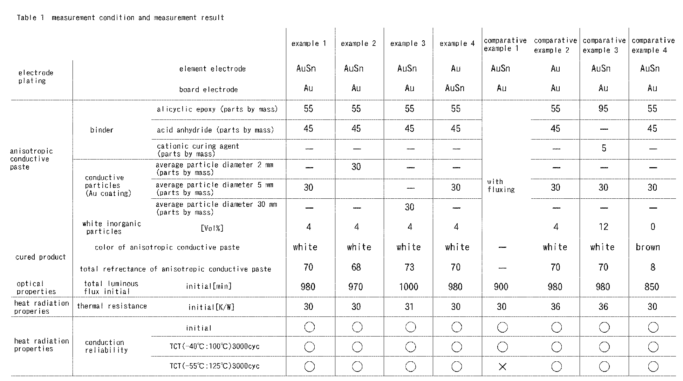

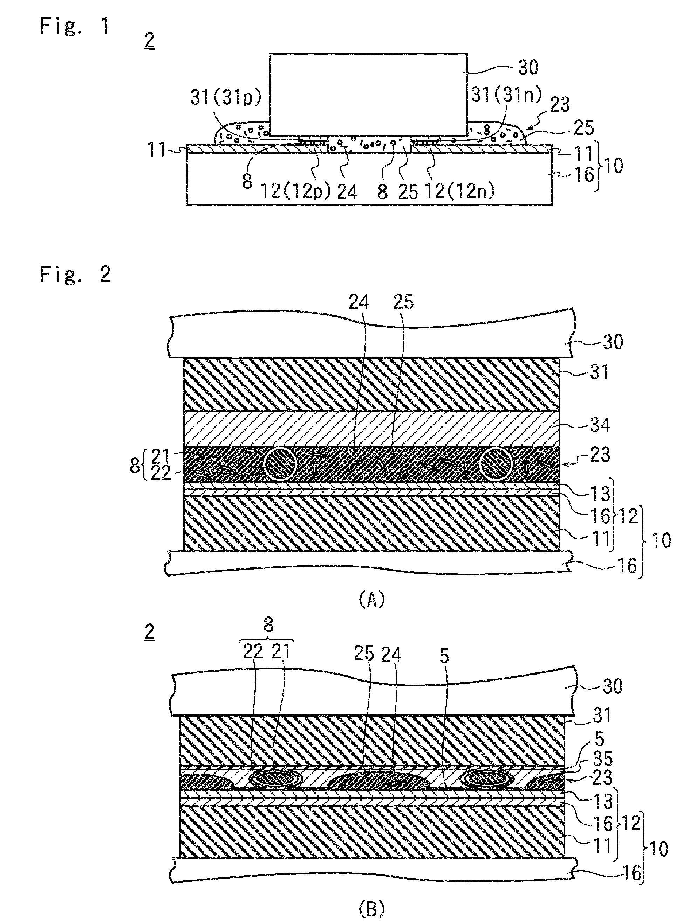

FIG. 1 is a cross-sectional view illustrating an exemplary light-emitting device 2 according to the present invention. Referring to FIG. 1, the light-emitting device 2 according to a first embodiment of the present invention has a board 10. The board 10 has a board body 16, a wiring pattern 11 formed on the board body 16, and an board electrode 12 provided in the board body 16 and connected to the wiring pattern 11. The board electrode 12 may also have a wiring film formed together with the wiring pattern 11.

A light-emitting element 30 which emits light when a current is flowed through the element 30 is arranged on the board 10.

The light-emitting element 30 is provided with an element electrode 31, and the element electrode 31 is electrically connected to the wiring pattern 11 through the board electrode 12.

Here, the light-emitting element 30 is a light-emitting diode (LED) chip, an inside thereof is provided with g p-type semiconductor region and n-type semiconductor region.

The p-type semiconductor region and n-type semiconductor region are partially exposed on the light-emitting element 30, and the element electrode 31 is connected to the exposed portion.

The p-type semiconductor region and n-type semiconductor region make contact with each other, so that a p-n junction is formed in the contacted interface.

Here, the element electrode 31 has a p-type element electrode 31p connected to the p-type semiconductor region and a n-type element electrode 31n connected to the n-type semiconductor region in the exposed portion on the light-emitting element 30, so that the p-type element electrode 31p and n-type element electrode 31n are electrically isolated.

The p-type element electrode 31p and n-type element electrode 31n are connected to different board electrodes 12, 12 insulated from each other. As a voltage is applied between the board electrode 12p connected to the p-type element electrode 31p and the board electrode 12n connected to the n-type element electrode 31n through the wiring pattern 11, a voltage is applied to the p-n junction through the p-type element electrode 31p and the n-type element electrode 31n.

If the p-n junction is forward-biased, an electric current flows to the p-n junction, so that the light-emitting element 30 emits light in the p-n junction part.

Here, as the board body 16, a ceramic board or a resin board such as polyimide, polyethylene naphthalate, and polyethylene terephthalate can be used. According to this embodiment, a ceramic board having excellent heat resistance can be used.

As a material of the wiring pattern 11, a metal such as Al, Cu, Ag, and Au or a conductive oxide material such as ITO (indium tin oxide) can be used.

In the board electrode 12, a metal film formed together with the wiring pattern 11 is used and a part of the wiring pattern 11 may be included, and further another metal film may also be produced separately from the wiring pattern 11.

In the light-emitting device 2, an anisotropic conductive paste 23 containing a thermosetting resin 25 is used when mounting the light-emitting element 30 onto the board 10, an anisotropic conductive paste 23 obtained by curing the thermosetting resin 25 is arranged in a gap between the surface of the light-emitting element 30 and the surface of the board 10 or the surface of the wiring pattern 11, and the light-emitting element 30 and the board 10 are mechanically fixed to each other by the cured anisotropic conductive paste 23.

Also, the light-emitting element 30 and the board 10 are also electrically connected to each other. FIG. 2(B) is an enlarged view illustrating an electric connection part between the light-emitting element 30 and the board 10 of the light-emitting device 2. The board electrode 12 of FIG. 2(B) is formed to make contact with the base layer 16 on a part of the wiring pattern 11, and on the base layer 16, an Au plating layer 13 is formed to make contact the base layer 16 through a plating method. The base layer 16 is a Ni layer. The base layer 16 improves a bonding strength between the Au plating layer 13 and the wiring pattern 11, and the base layer 16 also serves as a barrier layer for preventing diffusion of copper if the wiring pattern 11 is a copper pattern.

### <2. Method of Manufacturing Light-emitting Device>

A description will be made for a method of manufacturing the light-emitting device 2.

In this method, a flat board such as a glass board or a resin board is used for the board body 16. First, as illustrated in FIG. 2(A), the board 10 is arranged on a stand (not shown) such that the Au plating layer 13 of the board electrode 12 faces upward, and a film-like anisotropic conductive paste 23 is arranged on the board 10. In addition, the light-emitting element 30 is arranged on the anisotropic conductive paste 23 such that the element electrode 31 faces the underlying anisotropic conductive paste 23. In this state, the light-emitting element 30 is not fixed to the board 10 yet.

An AuSn alloy layer 34 is formed on the surface of the element electrode 31 through a plating method to make contact with the element electrode 31. One surface of the anisotropic conductive paste 23 makes contact with the Au plating layer 13 of the board electrode 12, and the other surface makes contact with the AuSn alloy layer 34 of the element electrode 31.

In this state, the light-emitting element 30 is pressed to the board 10 while heating the light-emitting element 30 and the board 10 by pressing the hot-pressing tool (not shown) onto the upward face of the light-emitting element 30. The board 10 may be pressed to the light-emitting element 30, that is, the light-emitting element 30 and the board 10 are pressed to a direction where a distance between the board 10 and the light-emitting element 30 is reduced.

The anisotropic conductive paste 23 contains an acid anhydride, white inorganic particles 24, and conductive particles 8 in addition to a thermosetting resin (here, an epoxy group-containing compound) 25. As the light-emitting element 30 and the board 10 are heated to a higher temperature, the anisotropic conductive paste 23 and the AuSn alloy layer 34 are also heated to a higher temperature.

The acid anhydride of the heated anisotropic conductive paste 23 has the properties which is formed on a surface of the metal layer making contact with the anisotropic conductive paste 23 and melt and remove oxides, so that oxides coated on the surface of the electrode such as the element electrode 31 and the board electrode 12 or the surface of the AuSn alloy layer 34 are melted and removed by the acid anhydride, and the metal surface is exposed (fluxing effect).

The exposed metal surface is highly reactive so that eutectic bonding with the AuSn alloy layer 34 as described below is easily formed.

Although the AuSn alloy layer 34 is melted at a lower temperature than that of an Au single-metal layer or a Sn single-metal layer, when the light-emitting element 30 is pressed to the board 10, first, the anisotropic conductive paste 23 is pressed by the AuSn alloy layer 34 which is in a solid state before melting.

Out of the distance between the light-emitting element 30 and the board 10, a distance of a part where the board electrode 12 and the element electrode 31 are facing each other is shorter than that of other parts. The anisotropic conductive paste 23 is unmelted and soft, and the anisotropic conductive paste 23 is pressed by the board electrode 12 and the element electrode 31 having solid surfaces, and is extruded from a gap between the board electrode 12 and the element electrode 31.

The AuSn alloy layer may also be formed on the board electrode 12, In this case, the anisotropic conductive paste is arranged between the AuSn alloy layer and the element electrode, and the anisotropic conductive paste is pressed by the AuSn alloy layer and the element electrode and is extruded from a gap between the board electrode and the element electrode. An Au plating layer may be provided on the surface of the element electrode having no AuSn alloy layer.

When the anisotropic conductive paste 23 is extruded from the gap between the board electrode 12 and the element electrode 31, a thin layer of the extruded anisotropic conductive paste 23 remains in the gap between the board electrode 12 and the element electrode 31.

As the light-emitting element 30 and the board 10 are further heated to a higher temperature, the AuSn alloy layer 34 is melted when being heated to a temperature over melting temperature, and a molten AuSn product is generated.

In this case, as the residue of the anisotropic conductive paste 23 is in a floatable state, when the molten AuSn product is pressed by the board electrode 12 and the element electrode 31, the molten AuSn product floats outward in the gap between the board electrode 12 and the element electrode 31, so that the residue of the anisotropic conductive paste 23 between the board electrode 12 and the element electrode 31 is forced to drift.

The anisotropic conductive paste 23 contains conductive particles 8, and when the residue of the anisotropic conductive paste 23 is forced to drift by the floating of the molten AuSn product, a plurality of conductive particles 8 remain in the gap between the board electrode 12 and the element electrode 31.

As the conductive particles 8 make contact with the board electrode 12 and the element electrode 31 and are pressed, the conductive particles 8 are crushed and nipped between the board electrode 12 and the element electrode 31 in this crushed state.

The light-emitting element 30 and the board 10 are continuously heated and pressed, and the surface of the board electrode 12, the surface of the element electrode 31, and the surfaces of the conductive particles 8 make contact with the molten AuSn product in a portion where no anisotropic conductive paste 23 remains. If this state is held for a predetermined time period, an eutectic portion 5 is formed, including eutectic crystals produced by Au and Sn of the molten AuSn product diffused into a portion making contact with the molten AuSn product out of the surface of the board electrode 12, and the surface of the element electrode 31, and the surfaces of the conductive particles 8.

Meanwhile, the thermosetting resin 25 of the anisotropic conductive paste 23 is cured by the temperature increase of the light-emitting element 30 and the board 10 after a predetermined reaction time. In particular, if the thermosetting resin 25 is an epoxy group-containing compound, the thermosetting resin 25 is reacted with the acid anhydride of the anisotropic conductive paste 23 and is cured.

The thermosetting resin 25 of the cured anisotropic conductive paste 23 is arranged in the light-emitting element 30 and the board 10, excluding the facing portion between the element electrode 31 and the board electrode 12. The light-emitting element 30 and the board 10 are mechanically connected (fixed) to each other by the cured thermosetting resin.

When the heating stops, and the light-emitting element 30 and the board 10 are cooled, the molten AuSn product is solidified.

FIG. 2(B) illustrates a state of the molten AuSn product after the solidification, and the reference numeral 35 denotes a solidified layer of molten AuSn formed by solidifying the molten AuSn product.

Out of the surface of the board electrode 12, and the surface of the element electrode 31, and the surfaces of the conductive particles 8, a portion making contact with the molten AuSn product is the metal layer. In the metal layer making contact with the molten AuSn product, Au and Sn are diffused, and the eutectic portion 5 including eutectic crystals is formed. Meanwhile, metals in the metal layer making contact with the molten AuSn product are also diffused into the molten AuSn product, and the eutectic portion 5 is formed.

Therefore, the solidified layer of molten AuSn 35 obtained by solidifying the molten AuSn product and the metal layer are electrically and mechanically connected to each other by the eutectic bonding. Therefore, the surface of the board electrode 12, the surface of the element electrode 31, and the surfaces of the conductive particles 8 are bonded to the solidified layer of molten AuSn 35 by the eutectic bonding.

The Au plating layer 13 is formed on the surface of the board electrode 12, and the Au coating layer 22 is formed on the surfaces of the conductive particles 8. Therefore, the board electrode 12 and the solidified layer of molten AuSn 35 are eutectically bonded by the eutectic portion 5 formed in a contact portion between the Au plating layer 13 and the molten AuSn product, and the conductive particles 8 and the solidified layer of molten AuSn 35 are eutectically bonded by the eutectic bonding formed in a contact portion between the Au coating layer 22 and the molten AuSn product.

The resin particles 21 are easily deformable, and a stress generated by pressing the gap between the light-emitting element 30 and the board 10 is alleviated by the deformation of the resin particles 21.

As the Au coating layer 22 makes contact with the board electrode 12 and the element electrode 31, the conductive particles 8 electrically connect the board electrode 12 and the element electrode 31, then, after the cooling, by virtue of a recovery force of the deformation of the squeezed resin particles 21, the Au coating layer 22 is held in a pressed state by the board electrode 12 and the element electrode 31 fixed to each other. Therefore, even when the eutectic bonding is broken, electrical connection between the board electrode 12 and the element electrode 31 is reliably maintained.

The light-emitting element 30 emits light when a voltage is applied between the element electrodes 31 by having a voltage applied to the wiring pattern 11, so that emergent light is emitted to the outside of the light-emitting element 30.

The white inorganic particles 24 contained in the anisotropic conductive paste 23 prevents light from being absorbed by irradiating the emergent light emitted from the light-emitting element 30 into Au or other light-absorbing substances. The emergent light from the light-emitting element 30 is irradiated to and is reflected by the white inorganic particles 24 before being absorbed by the light-absorbing substances, and is emitted to the outside of the light-emitting device 2. Therefore, light emission efficiency of the light-emitting device 2 is improved by the white inorganic particles 24.

In the aforementioned embodiment, the AuSn alloy layer 34 is arranged to make contact with the element electrode 31, however, the AuSn alloy layer 34 may be arranged to make contact with a surface of at least any one of electrodes between the board electrode 12 and the element electrode 31, and the present invention also contains the case that the AuSn alloy layer 34 is arranged to make contact with the both.

A composition of the AuSn alloy layer 34 has Au of 66 wt% or more and 87 wt% or less by assuming a total weight percentage of Au and Sn is set to 100 wt%.

Also, out of the board electrode 12 or the element electrode 31, the Au plating layer is preferably provided in the other electrode from the electrode with which the AuSn alloy layer 34 is arranged to closely contact.

If the electrode is composed such that a Ni layer is provided between the electrode where the Au plating layer is arranged and the Au plating layer, the Au plating layer becomes resistant to exfoliation (electrode/Ni layer/Au plating layer). Furthermore, if a Pd layer is provided between the Ni layer and the Au plating layer, the Au plating layer becomes more resistant to exfoliation (electrode/Ni layer/Pd layer/Au plating layer).

Moreover, in any one of electrodes between the board electrode 12 and the element electrode 31, an Au bump having A exposed on a surface or a solder bump having a solder exposed on a surface may be formed.

Pb-Sn, Sn-Ag, Au-Sn, and the like can be used as materials of the solder bump. Sn-Ag or Au-Sn is preferable among them.

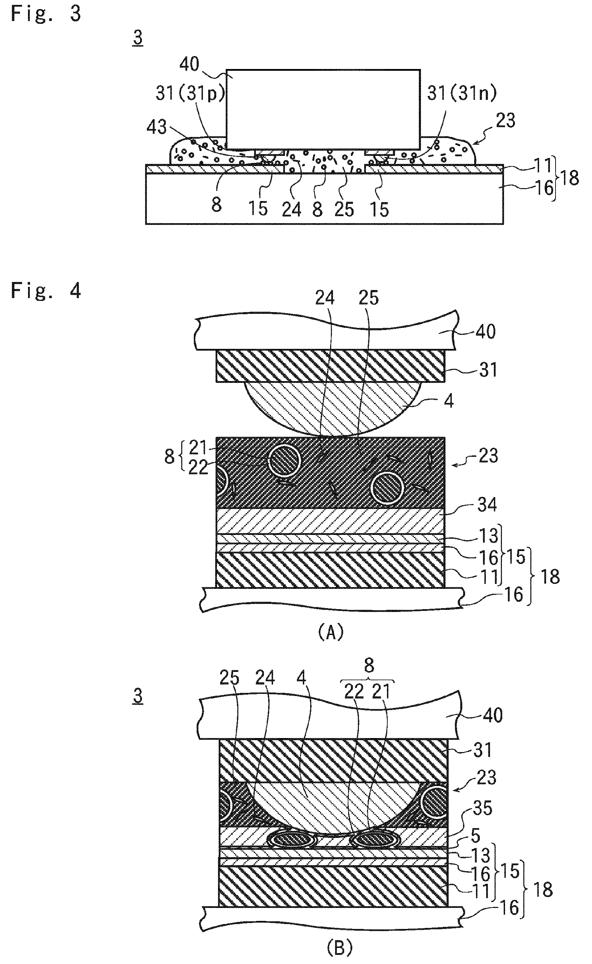

FIG. 3 illustrates a light-emitting device 3 according to a second embodiment of the present invention, in which an Au bump 4 is formed in any one of electrodes between the board electrode 15 and the element electrode 31 (here, the element electrode 31), and the AuSn alloy layer 34 is provided in the other electrode (here, the board electrode 15).

This light-emitting device 3 has a light-emitting element 40 and a board 18, and in the element electrode 31 of the light-emitting element 40, an n-type element electrode 31n and a p-type element electrode 31p are included, a voltage is applied between the n-type element electrode 31n and p-type element electrode 31p, and when the p-n junction within the light-emitting element 40 is forward-biased, the light-emitting element 40 emits light.

The Au bump 4 is provided in each of the n-type element electrode 31n and p-type element electrod 31p. In producing this light-emitting device 3, first, the board 18 is disposed on a stand, and the film-like anisotropic conductive paste 23 described above is disposed on the board 18 as illustrated in FIG. 4(A), and the Au bump 4 of the light-emitting element 40 is laid thereon.

The board 18 has a board body 16 and a wiring pattern 11 arranged on the board body 16, and the board body 16 is provided with a board electrode 15.

The board electrode 15 has a part of the wiring pattern 11, a base layer (Ni layer) 16 formed on the surface thereof, and an Au plating layer 13 formed on the surface of the base layer 16. On the surface of the Au plating layer 13, an AuSn alloy layer 34 making contact with the Au plating layer 13 is provided through plating.

As the light-emitting element 40 and the board 18 are pressed while being heated, the anisotropic conductive paste 23 is pressed by the Au bump 4 and the electrode having no Au bump 4 out of the board electrode 15 and the element electrode 31, so that the Au bump 4 is pushed into the anisotropic conductive paste 23 and makes contact with the AuSn alloy layer 34.

In this case, a plurality of conductive particles 8 are nipped between a single Au bump 4 and the AuSn alloy layer 34. In this state, as the AuSn alloy layer 34 is further heated and melted, the molten AuSn product makes contact with the Au bump 4 and the Au plating layer 13 provided in the electrode having no Au bump 4.

As described above, as the eutectic portion 5 is generated in the contact portion between the molten AuSn product and the Au bump 4 and the contact portion between the molten AuSn product and the Au plating layer 13, and the solidified layer of molten AuSn 35 is formed by solidifying the molten AuSn product as illustrated in FIG. 4B, the portion between the solidified layer of molten AuSn 35 and the Au bump 4 and the portion between the solidified layer of molten AuSn 35 and the Au plating layer 13 are bonded by the eutectic bonding.

The conductive particles 8 are contained in the molten AuSn product in a state where the Au coating layers 22 on the surfaces of the conductive particles 8 make contact with the surface of the Au bump 4 and the surface of the electrode having no Au bump 4 (here, the Au plating layer 13). The Au coating layer 22 on the surface of the conductive particle 8 makes contact with the molten AuSn product to form the eutectic portion 5 on its surface. As the molten AuSn product is cooled and solidified to form the solidified layer of molten AuSn 35, the portion between the solidified layer of molten AuSn 35 and the conductive particles 8 is also bonded by the eutectic bonding.

Since the conductive particles 8 are pressed by the Au bump 4 and the electrode having no Au bump 4, the Au coating layers 22 of the conductive particles 8 make contact with the Au bump 4 and the electrode having no Au bump 4 (here, the board electrode 15) inside the solidified layer of molten AuSn 35.

A state where the resin particles 21 are deformed by the thermosetting resin 25 used to fix the light-emitting element 40 and the board 18 is maintained, and the Au coating layer 22 is pressed by the Au bump 4 and the board electrode 15 or the element electrode 31 by a recovery force of the resin particles 21.

In the aforementioned light-emitting device 2 according to the first embodiment, the board electrode 12 and the element electrode 31 are electrically connected to each other by the Au coating layers 22 of the conductive particles 8, and in the light-emitting device 3 according to this embodiment, the electrode having no Au bump 4 out of the board electrode 15 and the element electrode 31 and the Au bump 4 are electrically connected to each other by the Au coating layers 22 of the conductive particles 8.

Therefore, even when a crack is generated in the solidified layer of molten AuSn 35 that mechanically connects the board electrode 12 and the element electrode 31 or the solidified layer of molten AuSn 35 that mechanically connects the electrode having no Au bump 4 out of the board electrode 15 and the element electrode 31 and the Au bump 4, the electrical connection between the board electrode 12, 15 and the element electrode 31 is maintained.

If the Au bump 4 is provided in the board electrode 15, the conductive particles 8 make contact with the Au bump 4 and the element electrode 31 to maintain the electrical connection.

It is noted that the Au bump 4 can be formed by forming a bump bonder on the electrode and then performing flattening process.

Although the Au bump 4 is used as a connecting bump for connecting the board electrode 15 and the element electrode 31 in the aforementioned embodiment, the solder bump also can be used as the connecting bump instead of the Au bump 4.

The light-emitting device according to the present embodiment may be sealed by a transparent mold resin as necessary such that the entire light-emitting device 2, 3 is covered. In addition, a light reflection layer may be provided in the light-emitting element 30, 40. Furthermore, as the light-emitting element 30, 40, well-known light-emitting elements other than an LED element can be used in such a range that the effects of the present invention are not damaged.

As conventionally, application of a flux for removing the oxide film on the surface of AuSn, solder, and the like thereby become unnecessary, and production efficiency can be improved.

### <3. Anisotropic Conductive Paste>

Next, a description will be made for the aforementioned anisotropic conductive paste 23 in more detail. The anisotropic conductive paste 23 according to the present embodiment is used in manufacture of the light-emitting device 2, 3 having the AuSn alloy layer 34 arranged to make contact with at least any one of electrodes between the board electrode or the electrode of the light-emitting element. The anisotropic conductive paste 23 contains a thermosetting resin 25, an acid anhydride, white inorganic particles 24, and conductive particles 8 which the resin particles 21 is covered by the Au coating layer 22.

As the epoxy compound used in the thermosetting resin 25, an alicyclic epoxy compound or a hydrogenated epoxy compound is preferably employed. As a result, it is possible to guarantee optical transparency suitable for packaging of an LED element and the like.

The alicyclic epoxy compound preferably contains two or more epoxy groups in a molecule. The alicyclic epoxy compound may be either liquid or solid. Specifically, 3,4-epoxy cyclohexenyl methyl-3',4'-epoxy cyclohexene carboxylate, glycidyl hexahydrobisphenol A, and the like can be given. Out of these materials, 3,4-epoxy cyclohexenyl methyl -3',4'-epoxy cyclohexene carboxylate is preferably employed from the point which can guarantee optical transparency and has excellent rapid curability.

As the hydrogenated epoxy compound, any hydrogenated epoxy compound known in the art can be employed, such as a hydrogen additive of the aforementioned alicyclic epoxy compound, a bisphenol A type, and a bisphenol F type.

The alicyclic epoxy compound or the hydrogenated epoxy compound may be used solely or in a combined manner of two or more types. In addition to the aforementioned epoxy compound, any other types of epoxy compounds may be employed simultaneously unless the effects of the present invention are harmed. For example, the alicyclic epoxy compound or the hydrogenated epoxy compound may contain any one selected from a group consisting of: glycidyl ethers obtained by reacting epichlorohydrin and polyhydric phenol such as bisphenol A, bisphenol F, bisphenol S, tetramethyl bisphenol A, diaryl bisphenol A, hydroquinone, catechol, resorcin, cresol, tetrabromobisphenol A, trihydroxybiphenyl, benzophenone, bisresorcinol, bisphenol hexafluoroacetone, tetramethyl bisphenol A, tetramethyl bisphenol F, tris-(hydroxy phenyl) methane, bixylenol, phenol novolak, and cresol novolak; polyglycidyl ethers obtained by reacting epichlorohydrin and aliphatic polyalcohol such as glycerine, neopentyl glycol, ethylene glycol, propylene glycol, ethylene glycol, hexylene glycol, polyethylene glycol, and polypropylene glycol; glycidyl ether esters obtained by reacting epichlorohydrin and hydroxy carboxylic acids such as a p-hydroxy benzoate, and a β-oxynaphthoic acid; polyglycidyl esters obtained from polycarboxylic acids such as a phthalic acid, a methylphthalic acid, an isophthalic acid, a terephthalic acid, a tetrahydrophthalic acid, an endo methylene tetrahydrophthalic acid, an endo methylene hexahydrophthalic acid, a trimellitic acid, and polymerized fatty acids; glycidyl aminoglycidyl ethers obtained from aninophenol or aminoalkylphenol; glycidyl aminoglycidyl esters obtained from an aminobenzoic acid; glycidylamines obtained from aniline, toluidine, tribromoaniline, xylylenediamine, diaminocyclohexane, bis(aminomethyl)cyclohexane, 4,4'-diaminodiphenyl methane, 4,4'-diaminodiphenylsulfone, or the like; and epoxy resins known in the art such as epoxidized polyolefin.
as the acid anhydride, specifically, methylhexahydrophthalic anhydride, 2,4-diethyl-1,5-pentane acid dianhydride, and the like can be given. Out of them, the methylhexahydrophthalic anhydride is preferably employed because it is possible to guarantee optical transparency suitable for packaging of LED elements of the cured product and provide excellent mutual solubility for the alicyclic epoxy compound. Since the acid anhydride has a fluxing effect, metal eutectic bonding can be performed with fluxless.

The mixing amount of the acid anhydride is preferably set to 0.7 to 1.3 equivalents per 1.0 equivalent of the epoxy compound. If the mixing amount of the acid anhydride is too small, an adhesive force tends to deteriorate. Otherwise, if the mixing amount of the acid anhydride is too large, corrosion resistance tends to deteriorate.

As the white inorganic particles, nonmetallic particles such as TiO₂, BN, ZnO, and Al₂O₃ are given, and their composition may be either a single composition or a composite composition. In addition, a refractive index of the white inorganic particles is preferably high and is more preferably higher than at least that of a binder. Furthermore, an average particle diameter of the white inorganic particles is preferably set to a half of or larger than the wavelength of the reflection light. Moreover, the average particle diameter of the white inorganic particles is preferably smaller than a height of the bump provided between the LED chip and the board electrode. Besides, the mixing amount of the white inorganic particles is set to 1 to 50 vol%, and preferably, 5 to 25 vol% against the binder.

If the white inorganic particles are mixed in this manner, it is possible to reflect the emergent light from the LED and obtain high light-extraction efficiency. In particular, assuming that a board subjected to Au plating highly resistant to corrosion is employed, if connection is performed by using only the AuSn eutectic bonding, the emergent light from the LED is absorbed in the Au plating, so that the luminous flux is reduced. In comparison, if the white inorganic particles are mixed, it is possible to obtain a high luminous flux.

As the conductive particles, for example, the Au coating layers may expose on the surfaces of resin particles such as epoxy resins, phenol resins, acryl resins, acrylonitrile·styrene (AS) resins, benzoguanamine resins, divinylbenzene-based resins, or styrene-based resins, and conductive particles having Au plating on the surfaces of the resin particles, conductive particles having Ni/Au plating, or conductive particles having Ni/Pd/Au plating can be employed.

The mixing amount of the conductive particles is preferably set to 1 to 100 parts by mass against 100 parts by mass of the binder.

Also, the average particle diameter of the conductive particles is preferably set to 2 µm or larger and 30 µm or smaller such that AuSn eutectic bonding between the chip electrode and the board electrode is performed and a repulsive effect caused by elasticity of the conductive particles even inside AuSn eutectic crystals can be obtained.

Moreover, the anisotropic conductive paste according to the present embodiment may further contain a silane coupling agent in order to improve adhesiveness on an interface with inorganic materials. As the silane coupling agent, an epoxy-based silane coupling agent, a methacryloxy-based silane coupling agent, an amino-based silane coupling agent, a vinyl-based silane coupling agent, a mercapto·sulfide-based silane coupling agent, an ureide-based silane coupling agent, and the like can be given, and these materials may be employed either solely or in a combined manner of two or more types. Out of them, according to the present embodiment, the epoxy-based silane coupling agent is preferably employed.

Furthermore, the adhesive may contain an inorganic filler in order to control fluidity and improve particle capturing efficiency. As the inorganic filler, especially not limited, but silica, talc, titanium oxide, calcium carbonate, magnesium oxide, and the like can be employed. Such the inorganic filler may also be suitably used in order to alleviate a stress of a structural body bonded by the adhesive. Furthermore, a softener such as a thermoplastic resin and a rubber component may also be combined.

### <4. Examples>

### Examples

A description will now be made of examples of the present invention. In this example, various anisotropic conductive pastes were manufactured, and a test was performed for colors and total reflectance. In addition, an LED package sample was manufactured by packaging the LED chip on the board using the anisotropic conductive paste, and a test was performed for a total luminous flux, a thermal resistance, and electrical conduction reliability. It is noted that the present invention is not limited to such examples.

### [Evaluation of Color]

The anisotropic conductive paste was applied on a white board made of ceramic until a thickness of 100 µm, was heated to a temperature of 200°C for one minute, and was then cured. For the resulting cured product, a whiteness level (JIS P8148) was measured by using a colorimeter. If the whiteness level is 70% or higher, it was evaluated as "white." If the whiteness level is lower than 70%, the color was evaluated visually.

### [Measurement of Total Reflectance]

The anisotropic conductive paste was applied on a white board made of cecramic until a thickness of 100 µm, was heated to a temperature of 200°C for one minute, and was then cured. For the resulting cured product, a total reflectance (for specular reflection and diffuse reflection) was measured for the light having a wavelength of 450 nm on the basis of barium sulphate by using a spectrophotometer (Model No. UV3100, produced by SHIMADZU Corporation).

### [Manufacture of LED package sample]

An LED packaging board (ceramic board having a conductor space of 100 µmP and an electrode plating of Ni (5.0 µm) and Au (0.3 µm)) and an LED chip (blue LED having an electrode thickness of 3 µm, an electrode plating of AuSn (5 µm), a forward voltage Vf of 3.1 V, and a forward current If of 50 mA) were prepared. Also, in Example 4, an LED packaging board having an electrode plated with AuSn (ceramic board with a conductor space of 100 µmP and an AuSn plating thickness of 5 µm) and an LED chip having an electrode plated with Au (blue LED having an electrode thickness of 3 µm, an electrode plating of Ni (5.0 µm) and Au (0.3 µm), a forward voltage Vf of 3.1 V, and a forward current If of 50 mA) were prepared.

The anisotropic conductive paste was applied to the LED packaging board, and the LED chip was then aligned and mounted. Through heating and compression bonding, an LED package sample was manufactured. A compression bonding condition in the manufacture of the LED package sample was set to a temperature of 305°C, a compression time of 30 sec, and a compression weight of 500 g/chip.

### [Measurement of Total Luminous Flux]

The measurement of the total luminous flux was performed by using a total luminous flux measurement system ((integral sphere) total luminous flux measurement system Model No. LE-2100, produced by OTSUKA ELECTRONICS Co., LTD.) based on an integral sphere. The measurement condition was set to a forward current If of 20 mA (static current control).

### [Measurement of Thermal Resistance]

The measurement of the thermal resistance was performed by using a dynamic type excessive thermal resistance measuring device (produced by Coper Electronics Co., Ltd.). The measurement condition was set to a forward current If of 50 mA, a measurement current Im of 1 mA, and thermal resistance value was read at the time of lighting for 0.1 sec.

### [Evaluation of Electrical Conduction Reliability Test]

For each LED package sample, a temperature cycle test (TCT) was performed. The LED package sample was picked out after 3,000 cycles, and a forward voltage Vf was measured with a forward current If of 20 mA. If an increase of the forward voltage Vf with respect to a reference forward voltage Vf on the test reference table of the LED chip is smaller than 5%, the corresponding LED chip was marked as "O." Otherwise, if an increase of the forward voltage Vf is equal to or larger than 5%, the corresponding LED chip was marked as "X."

The temperature cycle test set a test process of exposing a target sample for 30 minutes each under a high temperature atmosphere and a low temperature atmosphere to be one cycle, and this test process is performed a plurality of times. First, the temperature cycle test was performed by setting a low temperature to -40°C and a high temperature to 100°C, and then by setting a low temperature to -55°C and a high temperature to 125°C. The temperature cycle test performed by setting the low temperature to -40°C and the high temperature to 100°C is expressed as "-40°C:100°C," and the temperature cycle test performed by setting the low temperature to -55°C and the high temperature to 125°C is expressed as "-55°C:125°C."

The following Table 1 shows measurement conditions and measurement results in each of Examples and Comparative Examples.

### [Table 1]

### [Example 1]

An anisotropic conductive paste was obtained by dispersing 30 parts by mass of conductive particles having an average particle diameter of 5 µm (resin core, Au plating) and 4 vol% of white inorganic particles having an average particle diameter of 0.5 µm (TiO₂ with Si coats and A1 coats) having an refractive index of 2.71) into a binder (having a refractive index n of 1.45) mainly containing 55 parts by mass of an alicyclic epoxy compound (Product Name: CELLOXIDE 2021P, produced by Daicel Corporation) and 45 parts by mass of an acid anhydride (Product Name: MH700, produced by New Japan Chemical Co., Ltd.).

Table 1 shows each of the evaluation results of Example 1. The color of the anisotropic conductive film was white, and the initial total reflectance was 70%. In addition, the total luminous flux of the LED package sample was 980 mim, and the thermal resistance value was 30 K/W Furthermore, the initial conductivity test evaluation for the LED package sample resulted in "O", the conductivity evaluation after the temperature cycle test for "-40°C:100°C" resulted in "0" and the conductivity evaluation after the temperature cycle test for "-55°C:125°C" resulted in "O". Moreover, a cross section of the electrical bonding portion of the LED package sample was observed. As a result, it was confirmed that AuSn eutectic bonding was formed between the electrode of the LED chip side and the electrode of the board side, and conductive particles were suitably crushed and maintained between the electrodes.

### [Example 2]

An anisotropic conductive paste was prepared similar to Example 1 except that conductive particles subjected to Au plating has an average particle diameter of 2 µm.

Table 1 shows each of the test evaluation results of Example 2. The color of the anisotropic conductive film was white, and the initial total reflectance was 68%. In addition, the total luminous flux of the LED package sample was 970 mim, and the thermal resistance value was 30 K/W Furthermore, the initial conductivity test evaluation for the LED package sample resulted in "O", the conductivity evaluation after the temperature cycle test for "-40°C:100°C" resulted in "O", and the conductivity evaluation after the temperature cycle test for "-55°C:125°C" resulted in "O". Moreover, a cross section of the electrical bonding portion of the LED package sample was observed. As a result, it was confirmed that AuSn eutectic bonding was formed between the electrode of the LED chip side and the electrode of the board side, and conductive particles were suitably crushed and maintained between the electrodes.

### [Example 3]

An anisotropic conductive paste was prepared similar to Example 1 except that conductive particles subjected to Au plating has an average particle diameter of 30 µm.

Table 1 shows each of the evaluation results of Example 3. The color of the anisotropic conductive film was white, and the initial total reflectance was 73%. In addition, the total luminous flux of the LED package sample was 1000 mlm, and the thermal resistance value was 31 K/W Furthermore, the initial conductivity evaluation for the LED package sample resulted in "O", the conductivity evaluation after the temperature cycle test for "-40°C:100°C" resulted in "O", and the conductivity evaluation after the temperature cycle test for "-55°C: 125°C" resulted in "0". Moreover, a cross section of the electrical bonding portion of the LED package sample was observed. As a result, it was confirmed that AuSn eutectic bonding was formed between the electrode of the LED chip side and the electrode of the board side, and conductive particles were suitably crushed and maintained between the electrodes.

### [Example 4]

An anisotropic conductive paste was prepared similar to Example 1 except that an LED packaging board having an AuSn-plated electrode (ceramic board having a conductor space of 100 µmP and an AuSn plating thickness of 5 µm) and an LED chip having an Au-plated electrode (blue LED having an electrode thickness of 3 µm, an electrode plating of Ni (5.0 µm) and Au (0.3 µm), and a forward voltage Vf of 3.1 V (forward current If of 500 mA)) were employed.

Table 1 shows each of the evaluation results of Example 4. The color of the anisotropic conductive film was white, and the initial total reflectance was 70%. In addition, the total luminous flux of the LED package sample was 980 mlm, and the thermal resistance value was 30 K/W Furthermore, the initial conductivity evaluation for the LED package sample resulted in "O", the conductivity evaluation after the temperature cycle test for "-40°C:100°C" resulted in "O", and the conductivity evaluation after the temperature cycle test for "-55°C: 125°C" resulted in "0". Moreover, a cross section of the electrical bonding portion of the LED package sample was observed. As a result, it was confirmed that AuSn eutectic bonding was formed between the electrode of the LED chip side and the electrode of the board side, and conductive particles were suitably crushed and maintained between the electrodes.

### [Comparative Example 1]

An anisotropic conductive paste was prepared similar to Example 1 except that flux was employed instead of the anisotropic conductive paste.

Table 1 shows each of the evaluation results of Comparative Example 1. The total luminous flux of the LED package sample was 900 mim, and the thermal resistance value was 30 K/W In addition, the initial conductivity evaluation for the LED package sample resulted in "O", the conductivity evaluation after the temperature cycle test for "-40°C:100°C" resulted in "O", and the conductivity evaluation after the temperature cycle test for "-55°C: 125°C" resulted in "X". Furthermore, a cross section of the electrical bonding portion of the LED package sample was observed. As a result, it was confirm that AuSn eutectic bonding was formed between the electrode of the LED chip side and the electrode of the board side, but there was a crack in the AuSn eutectic bonding. Moreover, it is conceived that the total luminous flux reduces because the emergent light is absorbed by the Au plating around the chip.

### [Comparative Example 2]

An anisotropic conductive paste was prepared similar to Example 1 except that an LED chip plated with Au (blue LED having an electrode thickness of 3 µm, an electrode plating of Ni (5.0 µm) and Au (0.3 µm), and a forward voltage Vf of 3.1 V (If = 50 mA) was employed.

Table 1 shows each of the evaluation results of Comparative Example 2. The color of the anisotropic conductive film was white, and the initial total reflectance was 70%. In addition, the total luminous flux of the LED package sample was 980 mim, and the thermal resistance value was 36 K/W Furthermore, the initial conductivity evaluation for the LED package sample resulted in "O", the conductivity evaluation after the temperature cycle test for "-40°C:100°C" resulted in "O", and the conductivity evaluation after the temperature cycle test for "-55°C: 125°C" resulted in "0". Moreover, a cross section of the electrical bonding portion of the LED package sample was observed. As a result, it was confirmed that conductive particles were suitably crushed and maintained between the electrode of the LED chip side and the electrode of the board side, but there was a thin resin layer in an interface between the electrode of the LED chip side and the electrode of the board side. It is conceived that the thermal resistance value increases because the AuSn eutectic bonding-does not exist, and there is a resin layer in the interface.

### [Comparative Example 3]

An anisotropic conductive paste was prepared similar to Example 1 except that a binder (having a refractive index n of 1.45) mainly containing 95 parts by mass of an alicyclic epoxy compound (Product Name: CELLOXIDE 2021P, produced by Daicel Corporation) and 5 parts by mass of a cationic curing agent (aluminum chelate-based latent curing agent) was employed.

Table 1 shows each of the evaluation results of Comparative Example 3. The color of the anisotropic conductive film was white, and the initial total reflectance was 70%. In addition, the total luminous flux of the LED package sample was 980 mlm, and the thermal resistance value was 36 K/W Furthermore, the initial conductivity evaluation for the LED package sample resulted in "O", the conductivity evaluation after the temperature cycle test for "-40°C:100°C" resulted in "O", and the conductivity evaluation after the temperature cycle test for "-55°C:125°C" resulted in "O". Moreover, a cross section of the electrical bonding portion of the LED package sample was observed. As a result, it was confirmed that conductive particles were suitably crushed and maintained between the electrode of the LED chip side and the electrode of the board side, but AuSn eutectic bonding was not formed between the electrode of the LED chip side and the electrode of the board side, a thin resin layer in an interface between the electrode of the LED chip side and the electrode of the board side existed. It is conceived that the thermal resistance increases because there is no fluxing effect caused by the acid anhydride, and the resin layer exists in the interface.

### [Comparative Example 4]

An anisotropic conductive paste was prepared similar to Example 1 except that the white inorganic particles are not mixed.

Table 1 shows each of the evaluation results of Comparative Example 4. The color of the anisotropic conductive film was brown, and the initial total reflectance was 8%. In addition, the total luminous flux of the LED package sample was 850 mlm, and the thermal resistance value was 30 K/W Furthermore, the initial conductivity test evaluation for the LED package sample resulted in "O", the conductivity evaluation after the temperature cycle test for "-40°C:100°C" resulted in "O", and the conductivity evaluation after the temperature cycle test for "-55°C: 125°C" resulted in "0". Moreover, a cross section of the electrical bonding portion of the LED package sample was observed. As a result, it was confirmed that AuSn eutectic bonding was formed between the electrode of the LED chip side and the electrode of the board side, and conductive particles were suitably crushed and maintained between the electrodes. It is conceived that the total luminous flux decreases because the emergent light is absorbed by the Au plating around the chip.

As described above, by using both the AuSn eutectic bonding and the anisotropic conductive paste as the method of electrically bonding the electrode of the LED element and the board electrode, it is possible to obtain high connection reliability in an anti-reflow test and a thermal shock resistance test and a high heat radiation property by virtue of the metal bonding. In addition, according to the present packaging method, it is possible to simultaneously perform the AuSn eutectic bonding and the curing of the anisotropic conductive paste through a single try of the thermal compression bonding. Therefore, it is possible to improve a production efficiency.

### [Reference Signs and Numerals]

- 2, 3: light-emitting device
- 4: Au bump
- 5: eutectic portion
- 8: conductive particle
- 10, 18: board
- 11: wiring pattern
- 12, 15: board electrode
- 13: Au plating layer
- 21: resin particles
- 22: Au coating layer
- 23: anisotropic conductive paste
- 24: white inorganic particles
- 30, 40: light-emitting element
- 34: AuSn alloy layer
- 35: solidified layer of molten AuSn

## Claims

1. A light-emitting device comprising:
a board provided with a wiring pattern;
a board electrode provided in the board and connected to the wiring pattern;
a light-emitting element which emits light when a current is flowed; and
an element electrode provided in the light-emitting element and connected to a semiconductor region in an inside of the light-emitting element,
wherein the board electrode and the element electrode are electrically connected to each other, and when a voltage is applied to the board electrode, a current is flowed through the light-emitting element so as to emits light,
the light-emitting device further comprising ;
a solidified layer of molten AuSn formed by solidifying a molten AuSn product which is obtained from melting an AuSn alloy layer positioned between the board electrode and the element electrode in the state of the molten AuSn product contacting with both the board electrode and the element electrode,
and a plurality of conductive particles which are contained in an inside of the molten AuSn product and made contact with the board electrode and the element electrode when the molten AuSn product is solidified,
wherein the solidified layer of molten AuSn and the element electrode are connected with a eutectic bonding portion which is formed in a contact region where the solidified layer of molten AuSn and the element electrode are connected each other, and the solidified layer of molten AuSn and the board electrode are connected with the eutectic bonding portion which is formed in a contact region where the solidified layer of molten AuSn and the board electrode are connected each other.

2. The light-emitting device according to claim 1, wherein the AuSn alloy layer is formed through plating in any one of electrodes between the board electrode and the element electrode, an Au plating layer is formed in the other electrode, and
wherein the molten AuSn product is solidified in a state of making contact with the Au plating layer.

3. The light-emitting device according to claim 1 or 2,
wherein the conductive particles include resin particles and Au coating layers coated on the resin particles,
wherein the solidified layer of molten AuSn is formed by solidifying the molten AuSn product while the molten AuSn product is in contact with the Au coating layer, and
wherein an eutectic bonding portion is formed in a contact region between the solidified layer of molten AuSn and the Au coating layer where these layers are in contact with each other.

4. The light-emitting device according to claim 1, wherein the outside between the board electrode and the element electrode are bonded to each other by a cured product of an anisotropic conductive paste including white inorganic particles and the conductive particles.

5. The light-emitting device according to claim 4, wherein the cured product is an epoxy resin inclding an alicyclic epoxy compound or a hydrogenated epoxy compound.

6. The light-emitting device according to claim 1, wherein an average particle diameter of the conductive particles is at least 2 µm and at most 30 µm.

7. A light-emitting device comprising:
a board provided with a wiring pattern;
a board electrode provided in the board and connected to the wiring pattern;
a light-emitting element that emits light when a current is applied; and
an element electrode provided in the light-emitting element and connected to a semiconductor region in an inside of the light-emitting element,
wherein the board electrode and the element electrode are electrically connected to each other, and the light-emitting element emits light by flowing a current when a voltage is applied to the board electrode,
and the light-emitting device further comprising,
a connecting bump which is provided in any one of electrodes between the board electrode and the element electrode and which is a solder bump or an Au bump having Au exposed on a surface,
a solidified layer of molten AuSn formed by solidifying a molten AuSn product which is obtained by melting an AuSn alloy layer positioned between the other electrode and the connecting bump in a state such that the molten AuSn product is in contact with both the other electrode and the connecting bump,
a plurality of conductive particles which are contained in an inside of the molten AuSn product,
and the plurality of conductive particles are made contact with the board electrode and the element electrode when the molten AuSn product is solidified, and eutectic bonding portion formed on a region between the solidified layer of molten AuSn and the other being in contact with each other, and a region between the solidified layer of molten AuSn and the connecting bump being in contact with each other and they are connected by the eutectic bonding portion.

8. The light-emitting device according to claim 7, wherein the AuSn alloy layer is formed by plating on the other electrode.

9. The light-emitting device accoding to claim 8, wherein the Au plating layer formed by plating is arranged on a surface of the other electrode.

10. The light-emitting device accoding to any one of claims 7 to 9,
wherein the conductive particles include resin particles and Au coating layers coated on the resin particles,
wherein the solidified layer of molten AuSn is formed by solidifying the molten AuSn product which is in contact with the Au coating layer, and
wherein the solidified layer of molten AuSn and the Au coating layer are connected by the eutectic bonding portion formed in a region where the solidified layer of molten AuSn and the Au coating layer are in contact with each other.

11. An anisotropic conductive paste for fixing a light-emitting element on a board and connecting an element electrode on a board electrode electrically,
wherein a light-emitting device has the board and the light-emitting element, an AuSn alloy layer provided in at least any one of electrodes between the board electrode provided in the board and the element electrode provided in the light-emitting element, and an AuSn eutectic bonding layer is formed between the AuSn alloy layer and the other electrode,
the anisotropic conductive paste comprising:
an epoxy compound,
an acid anhydride,
white inorganic particles, and
conductive particles obtained by coating Au coating layers on resin particles.

12. An anisotropic conductive paste for fixing a light-emitting element on a board and connecting an element electrode on a board electrode electrically,
wherein a light-emitting device has the board and the light-emitting element, and between the board electrode provided in the board and the element electrode provided in the light-emitting element, at least any one of electrodes is provided a connecting bump which is a solder bump or an Au bump exposed Au on a surface, the other electrode is provided AuSn alloy layer,
and an AuSn eutectic bonding layer is formed between the connecting bunp and the AuSn alloy layer,
the anisotropic conductive paste comprising:
an epoxy compound,
an acid anhydride,
white inorganic particles, and
conductive particles obtained by coating Au coating layers on resin particles.

13. A method of manufacturing a light-emitting device,
the light-emitting device including:
a board provided with a wiring pattern;
a board electrode provided in the board and connected to the wiring pattern,
a light-emitting element that emits light when a current is applied, and
an element electrode provided in the light-emitting element and connected to a semiconductor region in an inside of the light-emitting element,
wherein the board electrode and the element electrode are electrically connected to each other, and when a voltage is applied to the board electrode, a current is flowed through the light-emitting element so as to emits light,
the method comprising the steps of:
forming an AuSn alloy layer by plating in at least any one of electrodes between the board electrode and the element electrode;
then, arranging the light-emitting element and the board in a state such that the other electrode and the AuSn alloy layer face each other while an anisotropic conductive paste including a thermosetting resin and conductive particles is arranged between the other electrode and the AuSn alloy layer;
pressing one of the light-emitting element and the board to the other one while heating,
forming a molten AuSn product melted from the AuSn alloy layer by pressing and heating the AuSn alloy layer and the other electrode so as to be in contact with the anisotropic conductive paste;
flowing out the anisotropic conductive paste from a gap between the element electrode and the board electrode while being the conductive particles in contact with the element electrode and the board electrode, and curing the thermosetting resin;
forming the solidified layer of molten AuSn by cooling and solidifying the molten AuSn product while being the molten AuSn product in contact with the element electrode, the board electrode, and the conductive particles, and being the conductive particles in contact with the element electrode and the board electrode; and
bonding by eutectic bonding portion formed in a region between the solidified layer of molten AuSn and the element electrode, and a region between the solidified layer of molten AuSn and the board electrode.

14. The method according to claim 13, further comprising the steps of:
including an acid anhydride in the anisotropic conductive paste, and
removing oxides formed on a surface of the AuSn alloy layer being in contact with the anisotropic conductive paste and a surface of the other electrode by melting.

15. The method according to claim 13, further comprising the steps of:
forming the Au plating layer on the other electrode in advance, and
solidifying the molten AuSn product being in contact with the Au plating layer.

16. The method according to any one of claims 13 to 15, wherein the conductive particles include resin particles and Au coating layers coated on the resin particles, the method further comprising the steps of:
solidifying the molten AuSn product being in contact with the Au coating layer and so as to form the solidified layer of molten AuSn, and
forming an eutectic bonding portion in a region between solidified layer of molten AuSn and the Au coating layer where these layers are in contact with each other.

17. The method according to claim 13, wherein an epoxy group-containing compound is used as the thermosetting resin, and the epoxy group-containing compound includes an alicyclic epoxy compound or a hydrogenated epoxy compound.

18. The method according to claim 13, wherein an average particle diameter of the conductive particles is at least 2 µm and at most 30 µm.
